# EUROPÄISCHE PATENTSCHRIFT

(11) **EP 2 705 413 B1**
(45) Veröffentlichungstag und Bekanntmachung des Hinweises auf die Patenterteilung: **10.06.2015**
(21) Anmeldenummer: 12714229.7
(22) Anmeldetag: 12.04.2012
(51) Int. Cl.: G05F 1/565, H04L 25/02, H05K 7/14, H02P 3/04

(54) **ANTRIEBSSYSTEM UND VERFAHREN ZUM BETREIBEN EINES ANTRIEBSSYSTEMS**
DRIVE SYSTEM AND METHOD FOR OPERATING A DRIVE SYSTEM
SYSTÈME D'ENTRAÎNEMENT ET PROCÉDÉ PERMETTANT DE FAIRE FONCTIONNER UN SYSTÈME D'ENTRAÎNEMENT

(30) Priorität: 03.05.2011 DE 102011100361
(43) Veröffentlichungstag der Anmeldung: 12.03.2014
(73) Patentinhaber: SEW-Eurodrive GmbH & Co. Kg ABT. ECG, 76646 Bruchsal (DE)
(72) Erfinder: SIMON, Olaf, 76646 Bruchsal (DE); SCHMIDT, Josef, 76676 Graben-Neudorf (DE); MEYROWITZ, Gunnar, 26123 Oldenburg (DE)
(86) Internationale Anmeldenummer: PCT/EP2012/001584
(87) Internationale Veröffentlichungsnummer: WO 2012/149996

(56) Entgegenhaltungen:
- DE-A1- 19 908 045
- DE-A1-102005 027 502
- DE-A1-102007 041 237
- DE-A1-102008 054 994
- DE-A1-102008 058 303
- DE-C1- 19 523 848
- US-B1- 6 790 050

## Beschreibung

Die Erfindung betrifft ein Antriebssystem und ein Verfahren zum Betreiben eines Antriebssystems.

Es ist bekannt, als Antriebssystem einen umrichtergespeisten Motor zu verwenden, wobei der Umrichter mit dem Motor über ein Kabel verbunden ist.

Aus der US 6 790 050 B1 ist ein Verteilerkasten bekannt, von dem ein T-Verteiler für Starksfromleitungen umfasst ist.

Aus der DE 199 08 045 A1 ist ein Kabelsystem zur Verkabelung mindestens eines Umrichters mit einem Elektromotor bekannt.

Aus der DE 10 2008 054 994 A1 ist ein Verfahren und eine Vorrichtung zur Spannungsversorgung von einem analogen Sensor bekannt.

Aus der DE 10 2008 058 303 A1 ist ein Verfahren zum Betreiben eines Antriebs bekannt.

Aus der DE 10 2007 041 237 A1 ist ein Verfahren und eine Vorrichtung zur Übertagung von Energie und Daten bekannt.

Aus der DE 10 2005 027 502 A1 ist eine Vorrichtung zu sicheren Ansteuerung einer elektromagnetisch betätigbaren Bremse bekannt.

Aus der DE 195 23 848 C1 ist ein Verfahren zum Betreiben eines Asynchronmotors bekannt.

Der Erfindung liegt daher die Aufgabe zugrunde, eine ein Antriebssystem weiterzubilden, wobei es mit geringem Installationsaufwand in einer Anlage installierbar sein soll.

Erfindungsgemäß wird die Aufgabe bei dem Antriebssystem nach den in Anspruch 1 und bei dem Verfahren nach den in Anspruch 13 angegebenen Merkmalen gelöst.

Wichtige Merkmale der Erfindung bei dem Antriebssystem sind, dass das Antriebssystem zumindest einen Elektromotor aufweist, welcher von einem Umrichter gespeist wird,
wobei der Umrichter und der Motor über ein Kabelsystem, insbesondere Hybridkabel, verbunden sind,
wobei das Kabelsystem Starkstromleitungen zur Versorgung des Motors und Schwachstromleitungen aufweist,
wobei die Schwachstromleitungen zwei Versorgungsleitungen zur Versorgung einer motorseitigen elektronischen Schaltung aufweisen,
wobei die Versorgungsleitungen die Bremsspule einer Bremse versorgen, insbesondere zur Erzeugung eines dem vom Motor erzeugten Drehmoment entgegenwirkenden Drehmoments beziehungswiese einer der vom Motor erzeugten Kraft entgegenwirkenden Kraft,
wobei die elektronische Schaltung über eine Spannungsanpassungsschaltung aus den Versorgungsleitungen versorgt wird, insbesondere zur Bereitstellung einer unabhängig vom Spannungspegel der Versorgungsleitungen erzeugten Versorgungsspannung für die elektronische Schattung,
insbesondere wobei der Motor ein Linearmotor oder rotatorischer Motor ist, wobei die beiden Versorgungsleitungen derart betrieben werden, dass sie entweder einen ersten höheren Spannungszustand, oder alternativ einen zweiten niedrigeren Spannungszustand aufweisen, und wobei diese beiden Spannungspegel zur Codierung einer Bremsansteuerungsinformation dienen.

Bei einer vorteilhaften Ausgestaltung ist **die Bremse, insbesondere die Wicklungszahl, die geometrischen Abmessungen und die Materialeigenschaften der Bremse mit Bremsspule, derart dimensioniert, dass sie bei einem Spannungspegel, welcher die Versorgungsspannung der elektronischen Schaltung überschreitet, gelüftet bleibt.** Von Vorteil ist dabei, dass die Bremse sogar direkt aus den Versorgungsleitungen ansteuerbar ist.

Bei einer vorteilhaften Ausgestaltung sind als elektronische Schaltung am Motor zumindest ein Sensor und ein Aktor angeordnet. Von Vorteil ist dabei, dass als Sensor beispielsweise ein Winkelsensor verwendbar ist.

Bei einer vorteilhaften Ausgestaltung teilt **die Spannungsanpassungsschaltung eine Versorgungsspannung für die elektronische Schaltung aus dem auf den Versorgungsleitungen herrschenden Spannungspegel herab.** Von Vorteil ist dabei, dass für die elektronische Schaltung eine gleichmäßige Spannung bereit gestellt wird.

Bei einer vorteilhaften Ausgestaltung ist im Strompfad zwischen einer Versorgungsleitung und der Bremsspule ein steuerbarer Schalter, insbesondere IGBT oder MOSFET, angeordnet zur Steuerung des Bremsspulenstroms. Von Vorteil ist dabei, dass der Bremsspulenstrom vom Pegel abhängig steuerbar ist, wobei sogar eine Schnellerregung der Bremse ausführbar ist, wobei ein Zeitglied in der Ansteuerschaltung für den Schalter verwendet wird. Außerdem ist der Schalter derart von der Ansteuerschaltung steuerbar, dass er offen, solange nicht der höhere der beiden Pegel auf den Versorgungsleitungen anliegt.

Bei einer vorteilhaften Ausgestaltung sind am Motor zumindest ein Sensor und ein Aktor angeordnet,
wobei der Umrichter und der Motor über ein Hybridkabel verbunden sind,
wobei das Hybridkabel Starkstromleitungen und Schwachstromleitungen aufweist,
wobei als Schwachstromleitungen zumindest zwei oder nur zwei Signalleitungen und zwei Versorgungsleitungen, insbesondere zur 24 Volt-Versorgung, verwendet sind,
wobei über die Signalleitungen die von den Sensoren erfassten Werte und, - insbesondere zeitlich versetzt - , die für den Aktor bestimmten Ansteuerdaten übertragbar sind.

Von Vorteil ist dabei, dass ein einziges Hybridkabel verwendbar ist und somit nur ein geringer Installationsaufwand ermöglicht ist. Da einem Kabel nur ein urnrichterseitiger Steckverbinder und/oder ein motorseitiger Steckverbinder zugeordnet wird, sind erhebliche Kosten einsparbar und die Verkabelung einer Anlage vereinfachbar, also übersichtlicher installierbar.

Bei einer vorteilhaften Ausgestaltung ist am Motor ein Temperatursensor, insbesondere ein in den Statorwicklungen des Motors angeordneter Temperatursensor, und/oder ein Winkelsensor angeordnet und ist als Aktor eine elektromagnetisch betätigbare Bremse, deren Bremsmoment der Rotorwelle des Motors zuleitbar. Von Vorteil ist dabei, dass verschiedene Sensoren verwendbar sind und die erfassten Sensordaten zusammen, also ein digitaler Datenstrom, dem Umrichter und dessen Steuerelektronik zuleitbar sind, so dass die erfassten Sensordaten beim Regeln des Antriebs verwendbar sind.

Bei einer vorteilhaften Ausgestaltung ist das Hybridkabel über eine Steckverbindung mit dem Motor und/oder über eine andere Steckverbindung mit dem Umrichter verbunden. Von Vorteil ist dabei, dass ein Hybridsteckverbinderteil verwendbar ist und somit Starkstromleitungen und Schwachstromleitungen gemeinsam verbindbar sind und somit eine einfache Installation ausführbar ist.

Bei einer vorteilhaften Ausgestaltung ist ein Mittel zur galvanischen Trennung, insbesondere ein Transformator, zwischen Motor und Leitungen des Hybridkabels, insbesondere Schwachstromleitungen des Hybridkabels angeordnet.
und/oder
ist ein Mittel zur galvanischen Trennung, insbesondere ein Transformator, zwischen Motor und Leitungen des Hybridkabels, insbesondere Schwachstromleitungen des Hybridkabels angeordnet. Von Vorteil ist dabei, dass eine verringerte Störeinwirkung von Fremdsignalen oder sonstigem Rauschen erreichbar ist. Insbesondere wird das Signal-Rauschverhältnis verbessert und die Sicherheit erhöht.

Bei einer vorteilhaften Ausgestaltung fungieren die Signalleitungen als differentielle Signalübertragungsleitungen. Von Vorteil ist dabei, dass ein besonders hohes Signal-Rauschverhältnis erreichbar ist und die Fehlübertragungen vermindert werden.

Bei einer vorteilhaften Ausgestaltung umfassen die Starkstromleitungen die Motorphasen-Zuleitungen (U,V,W,) und einen Nullleiter (PE). Von Vorteil ist dabei, dass der Starkstrom, also mehr als 1 Ampere übertragbar ist und das Hybridkabel diese Leitungen mit entsprechend großem Querschnitt aufnimmt. Die zu diesem Wechselstrom zugehörige Motorspannung liegt zwischen 100 Volt und 1000 Volt Effektivspannung.

Bei einer vorteilhaften Ausgestaltung ist im Motor ein ansteuerbarer Halbleiterschalter angeordnet, dem das Ansteuersignal vom Umrichter über die Signalleitungen des Hybridkabels zuführbar ist und welcher den dem Elektromagneten der Bremse zugeführten Strom steuert. Von Vorteil ist dabei, dass der Strom steuerbar ist und somit von der elektromagnetisch betätigbaren Bremse als steuerbarer Aktor ein Bremsmoment auf die Rotorwelle leitbar ist.

Bei einer vorteilhaften Ausgestaltung ist im Motor eine Leiterplatte angeordnet, insbesondere an einem zumindest teilweise gehäusebildenden Teil, und auf der Leiterplatte der Halbleiterschalter bestückt ist,
wobei auf der Leiterplatte auch ein magnetfeldsensitiver Sensor, insbesondere Halisensor und/oder Wiegandsensor, bestückt ist, welcher einem drehbar gelagerten Teil, insbesondere Lüfter, gegenüberstehend angeordnet ist, wobei am drehbar gelagerten Teil Dauermagnete angeordnet sind, die von dem magnetfeldsensitiven Sensor detektierbar sind beim Vorbeidrehen. Von Vorteil ist dabei, dass eine integrierte kompakte Ausführung ermöglicht ist.

Bei einer vorteilhaften Ausgestaltung ist auf der Leiterplatte eine Umsetzer angeordnet, welcher die über die Signalleitungen als digitale Information übertragenen Daten empfängt und daraus die Ansteuerinformationen für den Aktor, insbesondere den Halbleiterschalter, herausfiltert und die von den Sensoren, insbesondere Winkelsensor und Temperatursensor, zugeleiteten Signale als digitalen Datenstrom über die Signalleitungen an den Umrichter leitet. Von Vorteil ist dabei, dass mittels des Umsetzers nur wenige Signalleitungen notwendig sind, nämlich nur eine Datenleitung, die durch die beiden differentiell arbeitenden Signalleitungen realisiert sind.

Bei einer vorteilhaften Ausgestaltung sind im Hybridkabel zwei weitere Signalleitungen angeordnet, so dass das Antriebssystem in sicherheitsgerichteten Anlagen betreibbar ist,
insbesondere wobei der digitale Datenstrom redundant übertragen wird oder Prüfinformationen über den digitalen Datenstrom übertragen werden. Von Vorteil ist dabei, dass die Sicherheit in einfacher Weise erhöhbar ist und trotzdem eine einfache Installation erreichbar ist, da nur ein Hybridkabel verwendet ist.

Wichtige Merkmale bei dem Verfahren zum Betreiben eines Antriebssystems sind, dass das Antriebssystem zumindest einen Elektromotor aufweist, welcher von einem Umrichter gespeist wird,
wobei der Umrichter und der Motor über ein Kabelsystem, insbesondere Hybridkabel, verbunden sind,
wobei das Kabelsystem Starkstromleitungen zur Versorgung des Motors und Schwachstromleitungen aufweist,
wobei die Schwachstromleitungen zwei Versorgungsleitungen zur Versorgung einer motorseitigen elektronischen Schaltung aufweisen,
wobei die Versorgungsleitungen auch die Bremsspule einer Bremse, insbesondere einer mit dem Motor mechanisch verbundenen Bremse, versorgen, insbesondere zur Erzeugung eines dem vom Motor erzeugten Drehmoment entgegenwirkenden Drehmoments beziehungswiese einer der vom Motor erzeugten Kraft entgegenwirkenden Kraft,
wobei die elektronische Schaltung über eine Spannungsanpassungsschaltung aus den Versorgungsleitungen versorgt wird, insbesondere wobei eine unabhängig vom Spannungspegel der Versorgungsleitungen erzeugte Versorgungsspannung für die elektronische Schaltung bereit gestellt wird,
wobei zur Übertragung einer Bremsansteuerungsinformation auf den Versorgungsleitungen verschiedene Pegel umrichterseitig angelegt werden, insbesondere wobei die Signale motorseitig decodiert werden,
insbesondere wobei der Motor ein Linearmotor oder rotatorischer Motor ist.

Von Vorteil ist dabei, dass die Versorgungsleitungen zum Übertragen von Information verwendbar sind. Infolge der Spannungsanpassungsschaltung ist trotz der veränderlichen Spannungspegel auf den Versorgungsleitungen eine gleichmäßige Spannung für die elektronische Schaltung, insbesondere Winkelsensor, bereit stellbar. Vorteiligerweise lässt sich die Erfindung auf alle elektromotorischen Antriebe mit Bremse anwenden, also auch auf Linearmotoren und rotatorische Motoren.

Bei einer vorteilhaften Ausgestaltung werden **zwei verschiedene Pegel zur Codierung auf den Versorgungsleitungen verwendet, wobei bei dem niedrigeren Pegel ein Lüften der Bremse bewirkt wird und bei dem höheren der beiden Pegel ein Einfallen der Bremse bewirkt wird.** Von Vorteil ist dabei, dass eine Codierung zur Ansteuerung der Bremse in einfacher Weise ermöglicht ist.

Bei einer vorteilhaften Ausgestaltung werden auf den Signalleitungen Daten derart digital codiert übertragen, dass die zeitlichen Abschnitte negativer und positiver Spannung gleich lang sind, insbesondere wobei die zeitlichen Abschnitte jeweils derart kurz sind, dass als Mittel zur galvanischen Trennung verwendete Transformatoren nicht gesättigt werden.

Bei einer vorteilhaften Ausgestaltung werden auf den Signalleitungen Daten im Manchestercode übertragen, insbesondere wobei die Daten bidirektional übertragen werden, insbesondere wobei ein half Duplex Verfahren verwendet werden, insbesondere wobei die Daten der Sensoren und Aktoren seriell hintereinander in einem Datenwort übertragen werden.
Von Vorteil ist dabei, dass eine effektive störarme Signalübertragung bidirektional herstellbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

In der Figur 1 ist der Stand der Technik einer Kabelverbindung zwischen einem Frequenzumrichter FU und einem von diesem FU gespeisten Elektromotor gezeigt.

In der Figur 2 ist die erfindungsgemäße Kabelverbindung gezeigt.

In der Figur 3 ist ein Ausschnitt aus einem schematischen Schaltplan gezeigt.

In der Figur 4 ist schematischer Schaltplan eines erfindungsgemäßen Ausführungsbeispiels gezeigt.

In der Figur 5 ist eine Modifikation des Ausführungsbeispiel nach Figur 4 gezeigt.

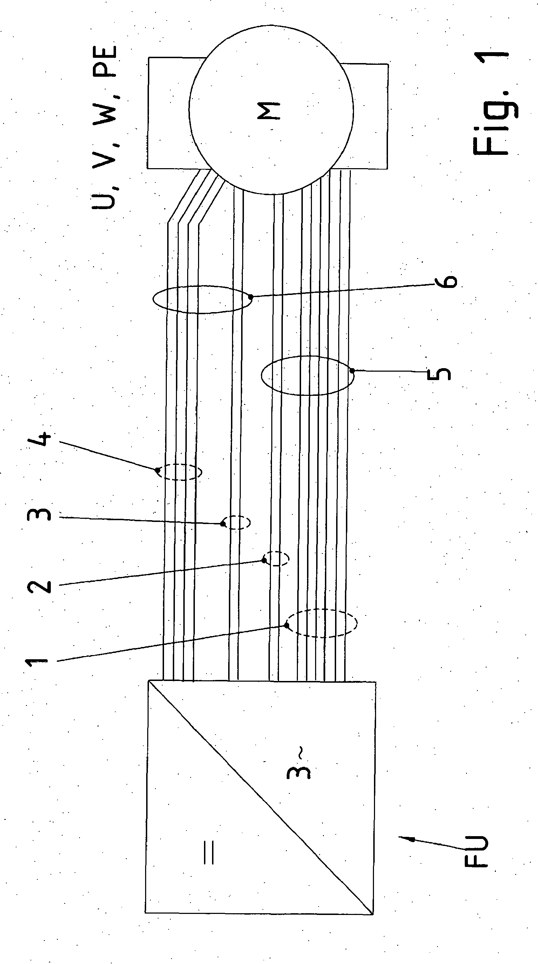

Im Stand der Technik gemäß Figur 1 ist bekannt, zwischen einem Umrichter FU und einem Elektromotor M eine Kabelverbindung zu schaffen, die verschiedene Leitungen für Schwachstrom und Starkstrom aufweist.

Dabei sind für jedes Kabel zumindest ein jeweiliger Steckverbinder vorgesehen, damit das Kabel vom Motor M, insbesondere ein Elektromotor, und/oder vom Umrichter FU trennbar ist. Vorzugsweise wird der Umrichter FU in einem Schaltschrank einer Anlage angeordnet, wohingegen der Motor M im maschinenbaulichen Teil der Anlage, also außerhalb des Schaltschrankes, angeordnet ist. Hierdurch ergeben sich hohe Kabellängen und komplexe Verdrahtungen.

In der Statorwicklung des Motors M ist zumindest ein Temperatursensor oder ein temperaturempfindlicher Schalter angeordnet. Außerdem ist ein Winkelsensor am Motor angeordnet, dessen Signale Information über die Winkellage der Rotorwelle des Elektromotors M enthalten. Des Weiteren ist am Motor M eine Bremse angeordnet, deren Bremskraft auf die Rotorwelle wirkt.

Somit sind als Verkabelung zwischen Umrichter FU und Motor M nicht nur die Starkstromleitungen 4 für die Phasen U, V, W des Motors M samt der zugehörige Nullleitung PE verwendet sondern auch Schwachstromleitungen. Dabei sind beispielhaft die Leitungen 1 zur Übertragung der vom Winkelsensor erfassten Information in einem Hybridkabel 5 zusammen mit den Starkstromleitungen U,V,W, PE angeordnet. Ein weiteres Kabel 6 mit Schwachstromleitungen 3 und 2 ist notwendig, da im Hybridkabel nicht ausreichend viele Schwachstromleitungen integrierbar sind. Dabei übertragen die Schwachstromleitungen 3 die Steuerspannung für die Bremse und die Schwachstromleitungen 2 die analog erfassten Temperaturwerte. Entsprechende Steckverbinder sind vorsehbar.

Zur Übertragung der Signale des Winkelsensors sind 6 oder mehr Leitungen notwendig, das jeder Spur dieses Gebers zwei Leitungen zugeordnet sind und der Geber mehr als eine Spur aufweist. Die Verarbeitung dieser Spursignale erfolgt dann im Umrichter FU.

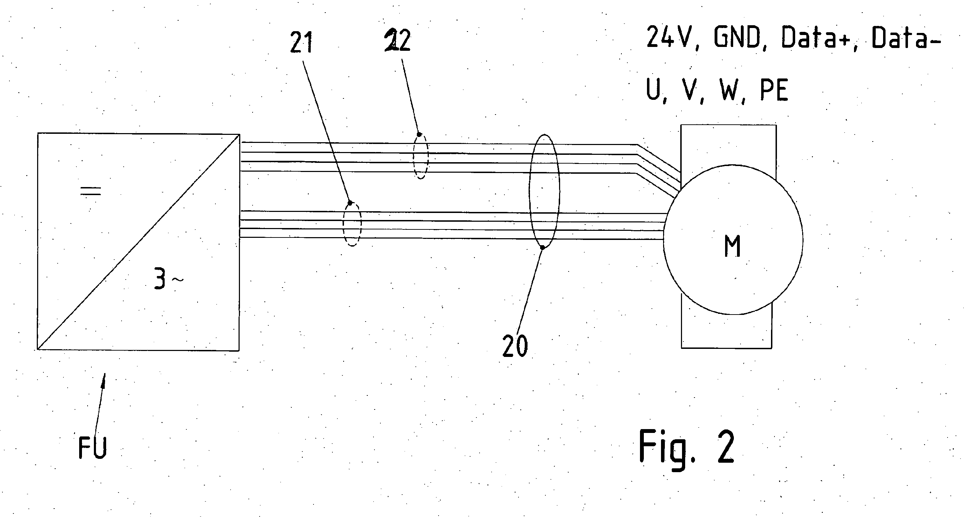

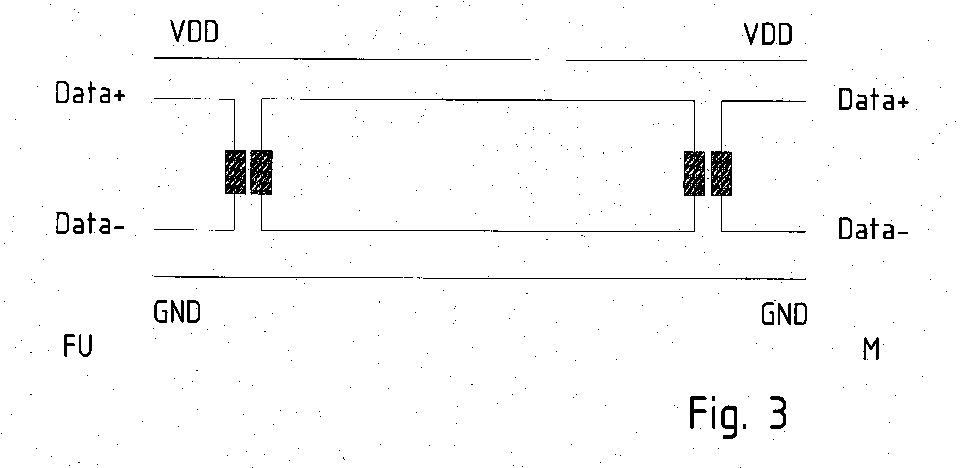

Bei der Erfindung gemäß den Figuren 2 und 3 wird im Unterschied zum Stand der Technik nach Figur 1 nur ein einziges Hybridkabel verwendet. Somit ist auch nur ein Hybridsteckverbinder zum Motor und/oder Hybridsteckverbinder zum Umrichter notwendig.

Dabei umfasst das Hybridkabel die Starkstromleitungen U,V,W, PE und zu sätzlich nur wenige Schwachstromleitungen. Dabei sind als Schwachstromleitungen in einem ersten Ausführungsbeispiel gemäß Figur 2 und 3 nur zwei Leitungen Data+ und Data- für ein differentielle Signalübertragung notwendig zusammen mit Versorgungsleitungen GND und VDD.

Wie in Figur 3 gezeigt ist eine galvanische Trennung, also Potentialtrennung, durch Verwendung eines umrichterseitigen und eines motorseitigen Transformators realisiert.

Durch Verwendung des Manchester Codes als Codierung bei der Signalübertragung ist sicher gestellt, dass die zeitlichen Abschnitte mit negativer und positiver Spannung gleich lang sind und die Transformatoren nicht gesättigt werden. Die Daten sind hierbei als Datenwort anordenbar, wobei jedes Datenwort beispielhaft zusammengesetzt ist, indem in einem ersten Wortanteil bremsenbezogene Daten, in einem zweiten Wortanteil temperatursensorbezogene Daten und in einem dritten Wortanteil winkelsensorbezogene Daten angeordnet werden. Die Kommunikation über die Signalleitungen ist bidirektional ausführbar, so dass die temperatursensorbezogenen Daten und winkelsensorbezogenen Daten vom Motor M an den Umrichter FU und die bremsenbezogenen Daten vom Umrichter FU an den Motor M übertragen werden.

Über diese Schnittstelle zwischen Umrichter und Motor können nun die Prozessdaten Lage und Temperatur vom Motor zum Umrichter übertragen und das Prozessdatum "Bremse ein " oder "Bremse aus" codiert vom Umrichter FU zum Motor M übertragen werden.

Über die Schwachstrom-Versorgungsleitungen ist die Bremse, der Temperatursensor und/oder der Geber versorgbar. Hierzu werden beispielhaft 24 Volt zwischen VDD und GND angelegt.

Die Bremse umfasst hierbei eine elektronische Schaltung, welche einen Elektromagneten der Bremse ansteuert. Hierzu wird die elektronische Schaltung über die genannten Schwachstrom-Versorgungsleitungen VDD und GND versorgt. Ein von der elektronischen Schaltung umfasster Leistungshalbleiterschalter steuert den Strom des Elektromagneten und empfängt sein Ansteuersignal über die Signalleitungen Data+ und Data-.

Die motorseitige und/oder umrichterseitige galvanische Trennung vermindert Störsignaleinwirkungen.

Vorzugsweise ist im Motor M eine Leiterplatte angeordnet, welcher die Signale der Sensoren zugeführt werden und von welcher dem Elektromagneten der Bremse, also des Aktors, sein ihm zugeordneter Steuerstrom zugeführt wird. Hierzu wird als am Motorgehäuse ein Hybridsteckverbinderteil angeordnet, in welches das Hybridkabel 20 mittels eines entsprechenden an einem Endbereich des Hybridkabels 20 angeordneten Gegensteckverbinderteils steckverbindbar ist und die zugehörigen Leitungen vom Steckverbinderteil zur Leiterplatte durchgeleitet werden.

Das Hybridkabel 20 umfasst vier Leitungen 21 für Schwachstrom, insbesondere zwei Leitungen für die differentielle Signalübertragung und zwei Leitungen für die Versorgungsspannungsdurchleitung, und Leitungen 22 für Leistung, insbesondere Starkstrom, also Motorphasen U, V, W und Nullleiter PE.

Vorteiligerweise ist hierbei die Leiterplatte mit auf ihr bestückten elektronischen Bauelementen als Teil des Winkelsensors ausführbar. Wenn nämlich auf der Leiterplatte magnetfeldsensitive Sensoren, insbesondere Hallsensoren und/oder Wiegandsensoren, angeordnet werden und die Leiterplatte derart im Motor angeordnet wird, dass diese magnetfeldsensitiven Sensoren einem drehenden, mit der Rotorwelle des Motors drehfest verbundenen Teil gegenüberstehend angeordnet sind, sind auf dem drehenden Teil Dauermagnete anordenbar, die von den magnetfeldsensitiven Sensoren detektierbar sind und somit die Winkelstellung erfassbar ist. Die Leiterplatte ist dabei beispielhaft an einem Flanschteil oder sonstigen Gehäuseteil des Motors befestigbar. Somit sind dieser Leiterplatte auch die weiter zugeleiteten Sensorsignale zuleitbar, insbesondere also diejenigen des Temperatursensors. Von der Leiterplatte ausgehend ist auch der Steuerstrom für den Elektromagneten der Bremse steuerbar. Vorzugsweise ist also auf der Leiterplatte auch eine elektronische Schaltung oder ein Bauteil vorsehbar, das als Umsetzer bezeichnet wird und eine Schnittstelle zwischen den Sensorsignalen und den Sigrialleitungen Data+ und Data- bildet. Somit ist ein Zusammenfassen der ausgehenden Datenströme und ein Separieren des eingehenden Datenstroms direkt auf derjenigen Leiterplatte ermöglicht, die auch die zur Detektion der Dauermagneten des drehenden Teils entsprechend bestückt ist. Somit ist eine bidirektionale Datenübertragung ermöglicht. Auf der Leiterplatte ist auch ein Speicher vorgesehen, dem über die Signalleitungen abzuspeichernde Parameter zuleitbar sind. Somit ist bei dem Betrieb des Winkelsensors eine Berücksichtigung dieser Parameter ermöglicht. Außerdem sind motorbezogene Daten in diesem Speicher, der vorzugsweise als Langzeitspeicher, wie EEPROM oder dergleichen, ausgeführt wird oder zumindest einen solchen Speicheranteil umfasst, so dass auch bei Stromausfall die gespeicherten Parameter nicht verloren gehen.

Als drehendes Teil ist vorzugsweise ein Lüfter verwendet, wobei die Dauermagnete im Lüfterring und/oder in den Lüfterflügeln und/oder in einem am Außenumfang angeordneten Luftleitring des Lüfters angeordnet sind.

Am Motor ist eine elektromagnetisch betätigbare Bremse angeordnet. Bei ausreichender Bestromung deren Elektromagneten, also Bremsspule, wird eine Ankerscheibe angezogen vom Elektromagneten, wobei eine gegenwirkende Federkraft überwunden wird. Die Ankerscheibe gibt dabei die Bremsbeläge frei, wodurch die Bremse gelüftet ist. Bei nicht ausreichender Bestromung drücken die die Federkraft erzeugenden Federelemente die Ankerscheibe auf den Bremsbelägträger, dessen Bremsbeläge somit wiederum auf eine Bremsfläche gedrückt werden. Die Bremse fällt dann also ein und erzeugt Bremsmoment beziehungsweise Bremskraft. Bei rotatorisch ausgeführtem Motor ist der Bremsbelagträger axial verschieblich und drehfest auf dem Rotor angeordnet. Die Ankerscheibe ist axial verschieblich angeordnet und drehfest am Motorgehäuse beziehungsweise Stator angeordnet.

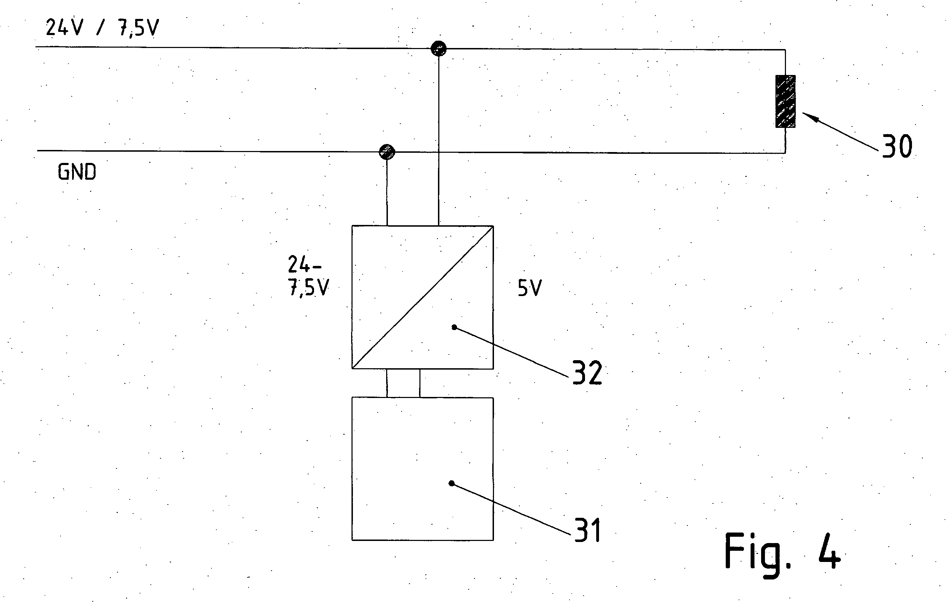

In Figur 4 sind zwei der Leitungen 21 für Schwachstrom als Versorgungsleitungen, ausgeführt, wobei diese derart betrieben werden, dass sie zwei Spannungszustände aufweisen, beispielhaft eine niedrige Spannung wie 7,5 Volt oder alternativ eine höhere Spannung 24 Volt. Aus diesen Versorgungsleitungen wird die Bremsspule 30 versorgt und über eine Spannungsanpassungsschaltung 32 eine elektronische Schaltung 31, wie Winkelsensor mit Auswertelektronik oder dergleichen. Dabei erzeugt die Spannungsanpassungsschaltung 32 aus der Spannung zwischen den Versorgungsleitungen (GND, 24V / 7.5 V) eine Versorgungsspannung 5 Volt für die elektronische Schattung 31.

Bei Anliegen des niedrigen Spannungspegels, also der beispielhaften 7,5 Volt, wird zwar die elektronische Schaltung 31 versorgt, jedoch bleibt die Bremse noch im eingefallenen Zustand, erzeugt also Bremsmoment beziehungsweise Bremskraft.

Bei Anliegen des hohen Spannungspegels, also der beispielhaften 24 Volt, wird nicht nur die elektronische Schaltung 31 versorgt sondern auch die Bremse wird derart ausreichend bestromt, dass die Bremse gelüftet wird.

Somit ist in den zwei Spannungspegeln die Bremsansteuerungsinformation codiert, wobei die elektronische Schaltung 31 stets versorgt ist. Die Information zur Bremsansteuerung ist also unabhängig von den Datenleitungen Data+ und Dataausführbar. Es sind sogar weitere Daten als binärer Datenstrom übertragbar, indem die beiden Spannungspegel als HIGH und LOW Signale verwendet werden.

Als elektronische Schaltung 31 ist vorzugsweise ein Winkelsensor mit Auswerteelektronik verwendet.

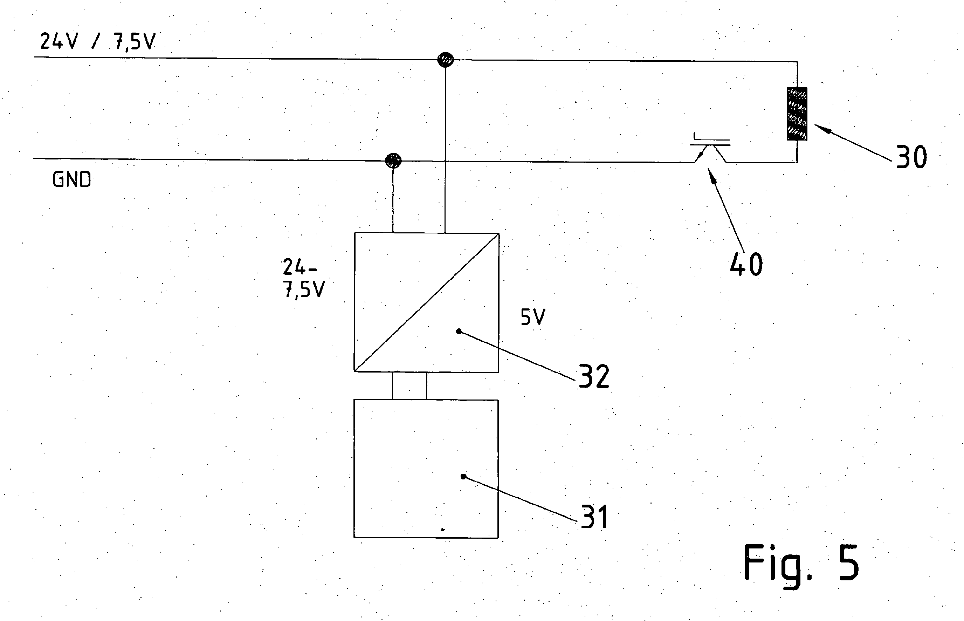

In Figur 5 wird ein steuerbarer Halbleiterschalter 40, insbesondere IGBT oder MOSFET, zur Steuerung des Spulenstroms verwendet, der von einer nicht gezeigten Ansteuerschaltung für den Halbleiterschalter 40, welcher die Versorgungsspannung zugeführt wird, erst bei dem hohen Spannungspegel, insbesondere also 24 Volt, der Schalter 40 in den leitenden Zustand versetzt wird.

Bei weiteren erfindungsgemäßen Ausführungsbeispielen wird die Bremse derart dimensioniert, dass sie bei beiden Spannungspegeln, also HIGH und LOW, gelüftet bleibt. Somit ist dann ohne störenden Einfluss auf den Bremszustand der binäre Datenstrom übertragbar.

Bei weiteren erfindungsgemäßen Ausführungsbeispielen sind nicht nur die genannten Sensoren, also Temperatursensor und Winkelsensor, vorgesehen sondern auch weitere Sensoren, deren Daten dann ebenfalls über die Signalleitungen übertragen werden. Außerdem ist nicht nur die Bremse als Aktor sondern es sind auch weitere Aktoren vorsehbar, wobei die zugehörigen Daten ebenfalls über die Signalleitungen übertragen werden. Hierzu ist wiederum einen bidirektionale Kommunikation ausführbar. Vorzugsweise wird ein half-Duplex-Verfahren hierbei verwendet.

Bei weiteren erfindungsgemäßen Ausführungsbeispielen werden zwei weitere Schwachstromleitungen als Signalleitungen im Hybridkabel angeordnet

### Bezugszeichenliste

1 Leitungen für Winkelsensor
2 Leitungen für Temperatursensor
3 Leitungen für Bremse
4 Leitungen für Leistung, insbesondere Starkstrom
5 Hybridkabel für Leistung und Bremse
6 Kabel für Sensoren
20 Hybridkabel
21 Leitungen für Schwachstrom
22 Leitungen für Leistung, insbesondere Starkstrom
30 Bremsspule
31 elektronische Schaltung, wie Winkelsensor mit Auswertelektronik oder dergleichen
32 Spannungsanpassungsschaltung
40 steuerbarer Halbleiterschalter, insbesondere IGBT oder MOSFET

M Elektromotor
FU Umrichter

## Patentansprüche

1. Antriebssystem, das zumindest einen Elektromotor (M) aufweist, welcher von einem Umrichter (FU) gespeist wird,
wobei der Umrichter (FU) und der Motor über ein Kabelsystem, insbesondere Hybridkabel (5, 20), verbunden sind,
wobei das Kabelsystem Starkstromleitungen (4) zur Versorgung des Motors und Schwachstromleitungen (21) aufweist,
wobei die Schwachstromleitungen (21) zwei Versorgungsleitungen zur Versorgung einer motorseitigen elektronischen Schaltung (31) aufweisen, insbesondere für einen Winkelsensor mit Auswertelektronik,
wobei die Versorgungsleitungen (21) die Bremsspule (30) einer Bremse versorgen, insbesondere zur Erzeugung eines dem vom Motor erzeugten Drehmoment entgegenwirkenden Drehmoments beziehungswiese einer der vom Motor erzeugten Kraft entgegenwirkenden Kraft,
**dadurch gekennzeichnet, dass**
die elektronische Schaltung (31) über eine Spannungsanpassungsschaltung (32) aus den Versorgungsleitungen (21) versorgt wird, insbesondere zur Bereitstellung einer unabhängig vom Spannungspegel der Versorgungsleitungen (21) erzeugten Versorgungsspannung für die elektronische Schaltung (31),
insbesondere wobei der Motor ein Linearmotor oder rotatorischer Motor ist,
wobei die beiden Versorgungsleitungen (21) derart betrieben werden, dass sie entweder einen ersten Spannungszustand aufweisen, bei dem sie eine niedrige Spannung, insbesondere wie 7,5 Volt, zur Verfügung stellen, oder alternativ einen zweiten Spannungszustand, bei dem sie eine höhere Spannung, insbesondere wie 24 Volt, zur Verfügung stellen, und
wobei diese beiden Spannungspegel zur Codierung einer Bremsansteuerungsinformation dienen.

2. Antriebssystem nach mindestens einem der vorangegangenen Ansprüche,
**dadurch gekennzeichnet, dass**
die Bremse, insbesondere die Wicklungszahl, die geometrischen Abmessungen und die Materialeigenschaften der Bremse mit Bremsspule (30), derart dimensioniert ist, dass sie bei einem Spannungspegel, welcher die Versorgungsspannung der elektronischen Schaltung überschreitet, gelüftet bleibt.

3. Antriebssystem nach mindestens einem der vorangegangenen Ansprüche,
**dadurch gekennzeichnet, dass**
als elektronische Schaltung (31) am Motor zumindest ein Sensor und ein Aktor angeordnet sind
und/oder dass
im Strompfad zwischen einer Versorgungsleitung und der Bremsspule (30) ein steuerbarer Schalter, insbesondere IGBT oder MOSFET, angeordnet ist zur. Steuerung des Bremsspulenstroms,
und/oder dass
**die Spannungsanpassungsschaltung (32) eine Versorgungsspannung für die elektronische Schaltung (31) aus dem auf den Versorgungsleitungen (3) herrschenden Spannungspegel herabteilt.**

4. Antriebssystem nach mindestens einem der vorangegangenen Ansprüche,
**dadurch gekennzeichnet, dass**
als Schwachstromleitungen **(21)** zumindest zwei oder nur eine oder zwei Signalleitungen **(1)** und zwei Versorgungsleitungen **(3),** insbesondere zur 24 Volt -Versorgung, verwendet sind,
wobei über die Signalleitungen **(1)** die von den Sensoren erfassten Werte und,-insbesondere zeitlich versetzt - , die für den Aktor bestimmten Ansteuerdaten übertragbar sind.

5. Antriebssystem nach mindestens einem der vorangegangenen Ansprüche,
**dadurch gekennzeichnet, dass**
am Motor ein Temperatursensor, insbesondere ein in den Statorwicklungen des Motors angeordneter Temperatursensor, und/oder ein Winkelsensor angeordnet ist und als Aktor eine elektromagnetisch betätigbare Bremse, deren Bremsmoment der Rotorwelle des Motors zuleitbar ist.

6. Antriebssystem nach mindestens einem der vorangegangenen Ansprüche,
**dadurch gekennzeichnet, dass**
das Hybridkabel (5, 20) über eine Steckverbindung mit dem Motor und/oder über eine andere Steckverbindung mit dem Umrichter (FU) verbunden ist.

7. Antriebssystem nach mindestens einem der vorangegangenen Ansprüche,
**dadurch gekennzeichnet, dass**
ein Mittel zur galvanischen Trennung, insbesondere ein Transformator, zwischen Motor und Leitungen des Hybridkabels (5, 20), insbesondere Schwachstromleitungen (21) des Hybridkabels (5, 20) angeordnet ist
und/oder
ein Mittel zur galvanischen Trennung, insbesondere ein Transformator, zwischen Motor und Leitungen (21) des Hybridkabels (5, 20), insbesondere Schwachstromleitungen (21) des Hybridkabels (5, 20) ahgeordnet ist

8. Antriebssystem nach mindestens einem der vorangegangenen Ansprüche,
**dadurch gekennzeichnet, dass**
die Signalleitungen **(1)** als differentielle Signalübertragungsleitungen fungieren.

9. Antriebssystem nach mindestens einem der vorangegangenen Ansprüche,
**dadurch gekennzeichnet, dass**
die Starkstromleitungen **(4, 22)** die Motorphasen-Zuleitungen (U,V,W,) und einen Nullleiter (PE) umfassen.

10. Antriebssystem nach mindestens einem der vorangegangenen Ansprüche,
**dadurch gekennzeichnet, dass**
im Motor ein ansteuerbarer Halbleiterschalter (40) angeordnet ist, dem das Ansteuersignal vom Umrichter (FU) über die Signalleitungen **(1)** des Hybridkabels (5, 20) zuführbar ist und welcher den dem Elektromagneten der Bremse zugeführten Strom steuert.

11. Antriebssystem nach mindestens einem der vorangegangenen Ansprüche,
**dadurch gekennzeichnet, dass**
im Motor eine Leiterplatte angeordnet ist, insbesondere an einem zumindest teilweise gehäusebildenden Teil, und auf der Leiterplatte der Halbleiterschalter (40) bestückt ist,
wobei auf der Leiterplatte auch ein magnetfeldsensitiver Sensor, insbesondere Hallsensor und/oder Wiegandsensor, bestückt ist, welcher einem drehbar gelagerten Teil, insbesondere Lüfter, gegenüberstehend angeordnet ist, wobei am drehbar gelagerten Teil Dauermagnete angeordnet sind, die von dem magnetfeldsensitiven Sensor detektierbar sind beim Vorbeidrehen,
und/oder dass
auf der Leiterplatte eine Umsetzer angeordnet ist, welcher die über die Signalleistungen **(1)** als digitale Information übertragenen Daten empfängt und daraus die Ansteuerinformationen für den Aktor, insbesondere den Halbleiterschalter (40), herausfiltert und die von den Sensoren, insbesondere Winkelsensor und Temperatursensor, zugeleiteten Signale als digitalen Datenstrom über die Signalleitungen (1) an den Umrichter (FU) leitet.

12. Antriebssystem nach mindestens einem der vorangegangenen Ansprüche,
**dadurch gekennzeichnet, dass**
im Hybridkabe (5, 20) zwei weitere Signalleitungen (1) angeordnet sind, so dass das Antriebssystem in sicherheitsgerichteten Anlagen betreibbar ist,
insbesondere wobei der digitale Datenstrom redundant übertragen wird oder Prüfinformationen über den digitalen Datenstrom übertragen werden.

13. Verfahren zum Betreiben eines Antriebssystems, insbesondere nach mindestens einem der vorangegangenen Ansprüche,
wobei das Antriebssystem zumindest einen Elektromotor (M) aufweist, welcher von einem Umrichter (FU) gespeist wird,
wobei der Umrichter (FU) und der Motor über ein Kabelsystem, insbesondere Hybridkabel (5, 20), verbunden sind,
**dadurch gekennzeichnet, dass**
das Kabelsystem Starkstromleitungen (4) zur Versorgung des Motors und Schwachstromleitungen (21) aufweist,
wobei die Schwachstromleitungen (21) zwei Versorgungsleitungen zur Versorgung einer motorseitigen elektronischen Schaltung (31) aufweisen, insbesondere für einen Winkelsensor mit Auswertelektronik,
wobei die Versorgungsleitungen (21) auch die Bremsspule (30) einer Bremse, insbesondere einer mit dem Motor mechanisch verbundenen Bremse, versorgen, insbesondere zur Erzeugung eines dem vom Motor erzeugten Drehmoment entgegenwirkenden Drehmoments beziehungswiese einer der vom Motor erzeugten Kraft entgegenwirkenden Kraft,
**dadurch gekennzeichnet, dass**
die elektronische Schaltung (31) über eine Spannungsanpassungsschaltung (32) aus den Versorgungsleitungen (21) versorgt wird, insbesondere wobei eine unabhängig vom Spannungspegel der Versorgungsleitungen (21) erzeugte Versorgungsspannung für die elektronische Schaltung (31) bereit gestellt wird,
wobei zur Übertragung einer Bremsansteuerungsinformation auf den Versorgungsleitungen (21) verschieden Pegel umrichterseitig angelegt werden,
nämlich als ersten Pegel eine niedrige Spannung, insbesondere wie 7,5 Volt, als zweiten Pegel eine höhere Spannung, insbesondere wie 24 Volt,
insbesondere wobei die Signale motorseitig decodiert werden,
insbesondere wobei der Motor ein Linearmotor oder rotatorischer Motor ist.

14. Verfahren nach mindestens einem der vorangegangenen Ansprüche,
**dadurch gekennzeichnet, dass**
zwei verschiedene Pegel zur Codierung auf den Versorgungsleitungen (3) verwendet werden,
wobei bei dem niedrigeren Pegel ein Lüften der Bremse bewirkt wird und bei dem höheren der beiden Pegel ein Einfallen der Bremse bewirkt wird.

15. Verfahren nach mindestens einem der vorangegangenen Ansprüche,
**dadurch gekennzeichnet, dass**
auf den Signalleitungen **(1)** Daten derart digital codiert übertragen werden, dass die zeitlichen Abschnitte negativer und positiver Spannung gleich lang sind, insbesondere wobei die zeitlichen Abschnitte jeweils derart kurz sind, dass als Mittel zur galvanischen Trennung verwendete Transformatoren nicht gesättigt werden,
und/oder
auf den Signalleitungen **(1)** Daten im Manchestercode übertragen werden,
insbesondere wobei die Daten bidirektional übertragen werden, insbesondere wobei ein half Duplex Verfahren verwendet werden,
insbesondere wobei die Daten der Sensoren und Aktoren seriell hintereinander in einem Datenwort übertragen werden.

## Claims

1. Drive system which comprises at least one electric motor (M) which is fed by a converter (FU),
wherein the converter (FU) and the motor are connected via a cable system, in particular hybrid cables (5, 20),
wherein the cable system comprises high-current lines (4) for supplying the motor and low-current lines (21),
wherein the low-current lines (21) comprise two supply lines for supplying a motor-side electronic circuit (31), in particular for an angle sensor with evaluation electronics,
wherein the supply lines (21) supply the brake coil (30) of a brake, in particular for generating a torque counteracting the torque generated by the motor or a force counteracting the force generated by the motor,
**characterised in that**
the electronic circuit (31) is supplied from the supply lines (21) via a voltage matching circuit (32), in particular for providing a supply voltage, generated independently of the voltage level of the supply lines (21), for the electronic circuit (31),
in particular wherein the motor is a linear motor or a rotary motor,
wherein the two supply lines (21) are operated in such a way that they have either a first voltage state, in which they provide a low voltage, in particular such as 7.5 volts, or alternatively a second voltage state, in which they provide a higher voltage, in particular such as 24 volts, and
wherein these two voltage levels serve for encoding brake control information.

2. Drive system according to at least one of the preceding claims,
**characterised in that**
the brake, in particular the number of windings, the geometrical dimensions and the material properties of the brake with brake coil (30), is dimensioned in such a way that it remains released at a voltage level which exceeds the supply voltage of the electronic circuit.

3. Drive system according to at least one of the preceding claims,
**characterised in that**
as the electronic circuit (31) at least one sensor and one actuator are arranged on the motor
and/or **in that**
in the current path between a supply line and the brake coil (30) a controllable switch, in particular IGBT or MOSFET, is arranged for controlling the brake coil current,
and/or **in that**
the voltage matching circuit (32) divides down a supply voltage for the electronic circuit (31) from the voltage level prevailing on the supply lines (3).

4. Drive system according to at least one of the preceding claims,
**characterised in that**
as the low-current lines (21) at least two or only one or two signal lines (1) and two supply lines (3), in particular for 24 volt supply, are used,
wherein the values acquired by the sensors and, - in particular temporally offset -, the control data determined for the actuator are transmittable via the signal lines (1).

5. Drive system according to at least one of the preceding claims,
**characterised in that**
on the motor a temperature sensor, in particular a temperature sensor arranged in the stator windings of the motor, and/or an angle sensor is arranged and as the actuator an electromagnetically actuatable brake, the braking torque of which is suppliable to the rotor shaft of the motor.

6. Drive system according to at least one of the preceding claims,
**characterised in that**
the hybrid cable (5, 20) is connected via a plug connection to the motor and/or via another plug connection to the converter (FU) .

7. Drive system according to at least one of the preceding claims,
**characterised in that**
a means for galvanic isolation, in particular a transformer, is arranged between the motor and the lines of the hybrid cable (5, 20), in particular the low-current lines (21) of the hybrid cable (5, 20)
and/or
a means for galvanic isolation, in particular a transformer, is arranged between the motor and the lines (21) of the hybrid cable (5, 20), in particular the low-current lines (21) of the hybrid cable (5, 20).

8. Drive system according to at least one of the preceding claims,
**characterised in that**
the signal lines (1) function as differential signal transmission lines.

9. Drive system according to at least one of the preceding claims,
**characterised in that**
the high-current lines (4, 22) comprise the motor-phase supply lines (U,V,W,) and a neutral conductor (PE).

10. Drive system according to at least one of the preceding claims,
**characterised in that**
in the motor a controllable semiconductor switch (40) is arranged, to which the control signal is suppliable from the converter (FU) via the signal lines (1) of the hybrid cable (5, 20) and which controls the current supplied to the electromagnet of the brake.

11. Drive system according to at least one of the preceding claims,
**characterised in that**
in the motor a printed circuit board is arranged, in particular on an at least partially housing-forming part, and the semiconductor switch (40) is fitted on the printed circuit board,
wherein a magnetic field-sensitive sensor, in particular Hall sensor and/or Wiegand sensor, is also fitted on the printed circuit board, which sensor is arranged opposite a rotatably mounted part, in particular fan, there being arranged on the rotatably mounted part permanent magnets which are detectable by the magnetic field-sensitive sensor as they rotate past,
and/or **in that**
on the printed circuit board is arranged a converter which receives the data transmitted via the signal lines (1) as digital information and filters out therefrom the control information for the actuator, in particular the semiconductor switch (40), and forwards the signals, supplied by the sensors, in particular angle sensor and temperature sensor, as a digital data stream via the signal lines (1) to the converter (FU).

12. Drive system according to at least one of the preceding claims,
**characterised in that**
two further signal lines (1) are arranged in the hybrid cable (5, 20), so that the drive system is operable in safety-oriented systems,
in particular wherein the digital data stream is transmitted redundantly or check information is transmitted via the digital data stream.

13. Method for operating a drive system, in particular according to one of the preceding claims,
wherein the drive system comprises at least one electric motor (M) which is fed by a converter (FU),
wherein the converter (FU) and the motor are connected via a cable system, in particular hybrid cables (5, 20),
**characterised in that**
the cable system comprises high-current lines (4) for supplying the motor and low-current lines (21),
wherein the low-current lines (21) comprise two supply lines for supplying a motor-side electronic circuit (31), in particular for an angle sensor with evaluation electronics,
wherein the supply lines (21) also supply the brake coil (30) of a brake, in particular of a brake mechanically connected to the motor, in particular for generating a torque counteracting the torque generated by the motor or a force counteracting the force generated by the motor,
**characterised in that**
the electronic circuit (31) is supplied from the supply lines (21) via a voltage matching circuit (32), in particular wherein a supply voltage, generated independently of the voltage level of the supply lines (21), is provided for the electronic circuit (31),
wherein for transmitting brake control information, different levels are applied on the converter-side to the supply lines (21),
namely as the first level a low voltage, in particular such as 7.5 volts, as the second level a higher voltage, in particular such as 24 volts,
in particular wherein the signals are decoded on the motor side,
in particular wherein the motor is a linear motor or a rotary motor.

14. Method according to at least one of the preceding claims,
**characterised in that**
two different levels are used for encoding on the supply lines (3),
wherein at the lower level a release of the brake is effected and at the higher of the two levels an application of the brake is effected.

15. Method according to at least one of the preceding claims,
**characterised in that**
on the signal lines (1) data is transmitted in such a digitally encoded way that the time periods of negative and positive voltage are of equal length, in particular wherein the time periods are in each case so short that transformers used as means for galvanic isolation are not saturated,
and/or
on the signal lines (1) data is transmitted in the Manchester code,
in particular wherein the data is transmitted bidirectionally, in particular wherein a half-duplex method is used,
in particular wherein the data of the sensors and actuators is transmitted serially one after another in a data word.

## Revendications

1. Système d'entraînement, qui présente au moins un moteur électrique (M), lequel est alimenté par un variateur (FU),
le variateur (FU) et le moteur étant reliés par un système de câbles, en particulier un câble hybride (5, 20),
le système de câbles présentant des lignes à courant fort (4) pour alimenter le moteur et des lignes à courant faible (21),
les lignes à courant faible (21) présentant deux lignes d'alimentation pour alimenter un circuit électronique (31) côté moteur, en particulier pour un capteur d'angle avec électronique d'évaluation,
les lignes d'alimentation (21) alimentant la bobine de frein (30) d'un frein, en particulier pour produire un couple s'opposant au couple produit par le moteur, respectivement une force s'opposant à la force produite par le moteur,
**caractérisé en ce que**
le circuit électronique (31) est alimenté par un circuit d'adaptation de tension (32) à partir des lignes d'alimentation (21), en particulier pour mettre à disposition une tension d'alimentation pour le circuit électronique (31) produite indépendamment du niveau de tension des lignes d'alimentation (21),
en particulier le moteur étant un moteur linéaire ou un moteur rotatif,
les deux lignes d'alimentation (21) fonctionnant de façon qu'elles présentent soit un premier état de tension dans lequel elles mettent à disposition une basse tension, en particulier telle que 7,5 volts, soit un deuxième état de tension dans lequel elles mettent à disposition une tension plus élevée, en particulier telle que 24 volts, et
ces deux niveaux de tension servant au codage d'une information de commande du frein.

2. Système d'entraînement selon au moins l'une des revendications précédentes,
**caractérisé en ce**
**que** le frein, en particulier le nombre d'enroulements, les dimensions géométriques et les propriétés des matériaux du frein avec bobine de frein (30) sont dimensionnés de façon que celui-ci reste desserré dans le cas d'un niveau de tension qui dépasse la tension d'alimentation du circuit électronique.

3. Système d'entraînement selon au moins l'une des revendications précédentes,
**caractérisé en ce**
**qu'**au moins un capteur et un actionneur sont disposés sur le moteur en tant que circuit électronique (31)
et/ou
**qu'**un commutateur commandable, en particulier un IGBT ou un MOSFET, est disposé dans le trajet du courant entre une ligne d'alimentation et la bobine de frein (30) pour commander le courant de bobine de frein,
et/ou
**que** le circuit d'adaptation de tension (32) abaisse par division une tension d'alimentation pour le circuit électronique (31) à partir du niveau de tension régnant sur les lignes d'alimentation (3).

4. Système d'entraînement selon au moins l'une des revendications précédentes,
**caractérisé en ce**
**qu'**au moins deux ou seulement une ou deux lignes de signalisation (1) et deux lignes d'alimentation (3), en particulier pour l'alimentation 24 volts, sont utilisées comme lignes à courant faible (21),
les valeurs détectées par les capteurs et les données de commande destinées à l'actionneur - en particulier décalées dans le temps - pouvant être transmises via les lignes de signalisation (1).

5. Système d'entraînement selon au moins l'une des revendications précédentes,
**caractérisé en ce**
**qu'**un capteur de température, en particulier un capteur de température disposé dans les enroulements de stator du moteur, et/ou un capteur d'angle et, en tant qu'actionneur, un frein actionnable par voie électromagnétique, dont le couple de freinage peut être transmis à l'arbre de rotor du moteur, sont disposés sur le moteur.

6. Système d'entraînement selon au moins l'une des revendications précédentes,
**caractérisé en ce que**
le câble hybride (5, 20) est relié au moteur par une connexion enfichable et/ou au variateur (FU) par une autre connexion enfichable.

7. Système d'entraînement selon au moins l'une des revendications précédentes,
**caractérisé en ce**
**qu'**un moyen de séparation galvanique, en particulier un transformateur, est disposé entre le moteur et les lignes du câble hybride (5, 20), en particulier les lignes à courant faible (21) du câble hybride (5, 20),
et/ou
**qu'**un moyen de séparation galvanique, en particulier un transformateur, est disposé entre le moteur et les lignes (21) du câble hybride (5, 20), en particulier les lignes à courant faible (21) du câble hybride (5, 20).

8. Système d'entraînement selon au moins l'une des revendications précédentes,
**caractérisé en ce**
**que** les lignes de signalisation (1) agissent comme des lignes de transmission de signaux différentielles.

9. Système d'entraînement selon au moins l'une des revendications précédentes,
**caractérisé en ce**
**que** les lignes à courant fort (4, 22) comprennent les lignes d'alimentation des phases du moteur (U, V, W) et un conducteur neutre (PE).

10. Système d'entraînement selon au moins l'une des revendications précédentes,
**caractérisé en ce**
**qu'**un commutateur à semi-conducteurs commandable (40) est disposé dans le moteur, auquel peut être amené le signal de commande du variateur (FU) via les lignes de signalisation (1) du câble hybride (5, 20) et lequel commande le courant amené à l'électro-aimant du frein.

11. Système d'entraînement selon au moins l'une des revendications précédentes,
**caractérisé en ce**
**qu'**une carte de circuits imprimés est disposée dans le moteur, en particulier sur une partie formant au moins partiellement le carter, laquelle est équipée du commutateur à semi-conducteurs (40),
la carte de circuits imprimés étant également équipée d'un capteur sensible au champ magnétique, en particulier un capteur à effet Hall et/ou un capteur Wiegand, lequel est disposé en face d'une partie montée tournante, en particulier d'un ventilateur, des aimants permanents étant disposés sur la partie montée tournante, lesquels sont détectables par le capteur sensible au champ magnétique lors de leur rotation devant celui-ci,
et/ou
**qu'**un convertisseur est disposé sur la carte de circuits imprimés, lequel reçoit les données transmises via les lignes de signalisation (1) sous la forme d'une information numérique, en extrait par filtrage les informations de commande pour l'actionneur, en particulier le commutateur à semi-conducteurs (40), et transmet au variateur (FU) les signaux provenant des capteurs, en particulier du capteur d'angle et du capteur de température, sous la forme d'un flux de données numériques via les lignes de signalisation (1).

12. Système d'entraînement selon au moins l'une des revendications précédentes,
**caractérisé en ce**
**que** deux autres lignes de signalisation (1) sont disposées dans le câble hybride (5, 20), de sorte que le système d'entraînement peut être utilisé dans des installations de sécurité,
en particulier le flux de données numériques étant transmis de façon redondante ou des informations de contrôle étant transmises via le flux de données numériques.

13. Procédé permettant de faire fonctionner un système d'entraînement, en particulier selon au moins l'une des revendications précédentes,
le système d'entraînement présentant au moins un moteur électrique (M), lequel est alimenté par un variateur (FU),
le variateur (FU) et le moteur étant reliés par un système de câbles, en particulier un câble hybride (5, 20),
**caractérisé en ce que**
le système de câbles présente des lignes à courant fort (4) pour alimenter le moteur et des lignes à courant faible (21),
les lignes à courant faible (21) présentant deux lignes d'alimentation pour alimenter un circuit électronique (31) côté moteur, en particulier pour un capteur d'angle avec électronique d'évaluation,
les lignes d'alimentation (21) alimentant aussi la bobine de frein (30) d'un frein, en particulier d'un frein relié mécaniquement au moteur, en particulier pour produire un couple s'opposant au couple produit par le moteur, respectivement une force s'opposant à la force produite par le moteur,
**caractérisé en ce que**
le circuit électronique (31) est alimenté par un circuit d'adaptation de tension (32) à partir des lignes d'alimentation (21), en particulier une tension d'alimentation pour le circuit électronique (31) produite indépendamment du niveau de tension des lignes d'alimentation (21) étant mise à disposition,
différents niveaux étant appliqués côté variateur sur les lignes d'alimentation (21) pour transmettre une information de commande du frein,
à savoir comme premier niveau une basse tension, en particulier telle que 7,5 volts, comme deuxième niveau une tension plus élevée, en particulier telle que 24 volts,
en particulier les signaux étant décodés côté moteur,
en particulier le moteur étant un moteur linéaire ou un moteur rotatif.

14. Procédé selon au moins l'une des revendications précédentes,
**caractérisé en ce**
**que** deux niveaux différents sont utilisés pour le codage sur les lignes d'alimentation (3),
le niveau plus bas provoquant un desserrage du frein et le niveau plus élevé des deux niveaux provoquant un serrage du frein.

15. Procédé selon au moins l'une des revendications précédentes,
**caractérisé en ce**
**que** les données sont codées numériquement sur les lignes de signalisation (1) de façon que les tranches de temps de tension négative et positive soient de même longueur, en particulier les tranches de temps étant chacune assez courte pour que des transformateurs utilisés comme moyens de séparation galvanique ne soient pas saturés,
et/ou
les données sont transmises en codage Manchester sur les lignes de signalisation (1),
en particulier les données étant transmises de façon bidirectionnelle, en particulier un procédé semi-duplex étant utilisé,
en particulier les données des capteurs et actionneurs étant transmises en série les unes derrière les autres dans un mot de données.
